(19) Europäisches Patentamt
European Patent Office
Office européen des brevets

(11) **EP 2 149 924 B1**

(12) **FASCICULE DE BREVET EUROPEEN**

(45) Date de publication et mention de la délivrance du brevet:
**16.05.2012 Bulletin 2012/20**

(51) Int Cl.:
***H01L 51/10*** *(2006.01)*

(21) Numéro de dépôt: **09305586.1**

(22) Date de dépôt: **23.06.2009**

(54) **Transistor organique et procédé de fabrication d'une couche diélectrique d'un tel transistor**

Organischer Transistor und Verfahren zur Herstellung einer dielektrischen Schicht eines solchen Transistors

Organic transistor and method for manufacturing a dielectric layer of such a transistor

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **31.07.2008 FR 0855300**

(43) Date de publication de la demande:
**03.02.2010 Bulletin 2010/05**

(73) Titulaire: **Commissariat à l'Énergie Atomique et aux Énergies Alternatives 75015 Paris (FR)**

(72) Inventeurs:
• **Benwadih, Mohamed
94500 Champigny sur Marne (FR)**
• **Serbutoviez, Christophe
38500 Voiron (FR)**

(74) Mandataire: **Vuillermoz, Bruno et al
Cabinet Laurent & Charras
"Le Contemporain"
50, Chemin de la Bruyère
69574 Dardilly Cédex (FR)**

(56) Documents cités:
**WO-A-2007/074404     US-A1- 2005 285 102
US-A1- 2007 215 957**

• **DAVID R LIDE: "CRC HANDBOOK OF CHEMISTRY AND PHYSICS" 1 janvier 2008 (2008-01-01), TAYLOR AND FRANCIS GROUP, LLC , XP002518007 * pages 13-13 ***
• **DAVID R LIDE: "CRC HANDBOOK OF CHEMISTRY AND PHYSICS" 1 janvier 2008 (2008-01-01), TAYLOR AND FRANCIS GROUP, LLC , XP002518008 * pages 12-44 - pages 12-52 ***

## Description

## DOMAINE DE L'INVENTION

La présente invention a trait au domaine des transistors organiques, comme par exemple les transistors à film mince plus communément connus sous l'expression anglo-saxonne « OTFT » (pour «*Organic thin film transistor*»).

## ETAT DE LA TECHNIQUE

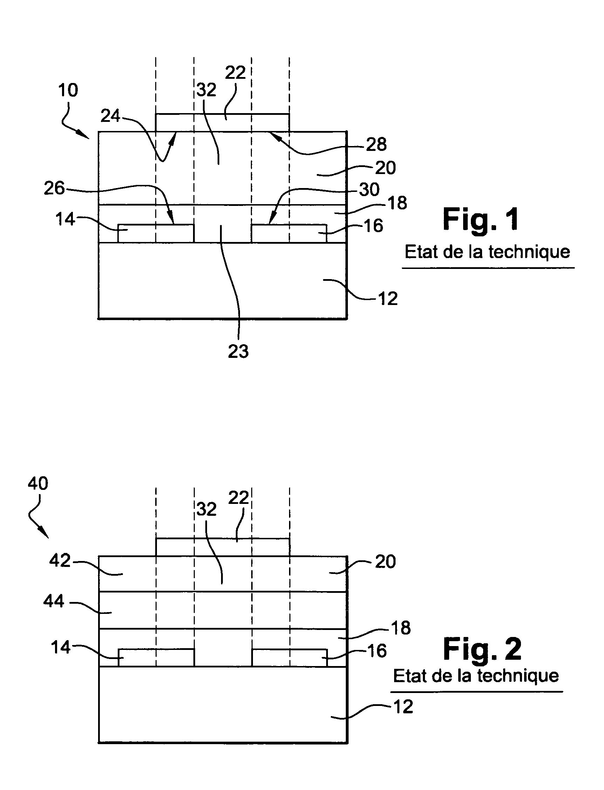

Sur la figure 1, il est représenté un transistor organique à film mince **10** selon l'état de la technique présentant une structure « grille haute - contact bas ».
Le transistor **10** comporte un substrat **12**, sur lequel sont formés deux éléments conducteurs **14**, **16** constituant respectivement le drain et la source du transistor **10**. Une couche semi-conductrice **18** est déposée sur le drain **14** et la source **16**, la couche semi-conductrice **18** étant elle-même recouverte par une couche de diélectrique **20**, sur laquelle est formé un troisième élément conducteur **22**, constituant la grille du transistor **10**.
Comme cela est connu en soi, l'effet transistor est obtenu en appliquant une tension entre la grille **22** et le substrat **12** de manière à créer, dans la couche semi-conductrice **18**, un canal de porteurs **23** entre le drain **14** et la source **16**. Pour obtenir un canal **23** qui s'étende avec certitude du drain **14** à la source **16**, la grille **22** recouvre partiellement ceux-ci. Ainsi, la grille **22** présente une surface **24** en regard d'une surface **26** du drain **14** et une surface **28** en regard d'une surface **30** de la source **16**.
Toutefois, deux conducteurs ayant des surfaces en regard et séparés par une couche diélectrique forment une capacité. On observe ainsi que des capacités parasites existent d'une part entre la grille **22** et le drain **14**, et d'autre part entre la grille **22** et la source **16** en raison des surfaces en regard **24** et **26** et des surfaces en regard **28** et **30**.
Pour diminuer de telles capacités parasites, la couche diélectrique **20** peut être constituée d'un diélectrique de faible permittivité électrique relative, ou diélectrique « low k », caractérisé par des valeurs de permittivité relative inférieure à 4.
Or, plus un matériau présente une permittivité électrique relative faible, plus il est difficilement polarisable. De fait, la diminution de la permittivité de la couche diélectrique **20** s'accompagne d'une augmentation de la tension d'alimentation entre la grille **22** et le substrat **12** pour créer le canal de porteurs entre le drain **14** et la source **16**.
Augmenter la tension d'alimentation pose cependant des problèmes de coût et nécessite des transistors de plus grandes surfaces qui puissent supporter des tensions plus élevées. La réalisation de transistors organiques de grande surface nécessite usuellement la mise en oeuvre de techniques de fabrication par voie liquide ou d'impression. Or, ce type de techniques est généralement efficace avec des semi-conducteurs de type P, mais s'avère de mise en oeuvre difficile pour des conducteurs de type N, ce qui réduit d'emblée le type de transistors réalisables.
Une autre solution consiste à diminuer l'épaisseur de la couche de diélectrique **20** afin de réduire les capacités parasites. Cependant la diminution de l'épaisseur de cette couche s'accompagne notamment d'une augmentation des courants de fuite et de l'instabilité électrique du transistor.
En outre, en modifiant les propriétés globales de la couche diélectrique **20,** notamment pour diminuer les capacités parasites, on modifie également la capacité de la région **32** de la couche diélectrique **20** agencée au dessus du canal **23.** Or, cette capacité doit être élevée, notamment pour éviter des phénomènes d'hystérésis qui nuisent à la qualité du transistor **10.**
Pour pallier certains de ces inconvénients, il a été proposé, un transistor dont la permittivité diélectrique relative de la couche semi-conductrice varie en fonction de son épaisseur. Ce transistor **44,** illustré à la figure 2, est analogue à celui décrit en relation avec la figure 1, à la différence que la couche diélectrique **20** comporte une première sous-couche **42** de diélectrique à forte permittivité diélectrique relative, ou matériau « high k », du côté grille, et une seconde sous-couche **44** de diélectrique « low k », du côté source et drain.
Comme cela est connu en soi, un diélectrique « high k » est caractérisé par une permittivité diélectrique relative supérieure ou égale à 4, certains matériaux « high k » ayant une permittivité diélectrique relative pouvant aller jusqu'à 100, voire même au-delà.
Un tel agencement permet de diminuer la tension d'alimentation du diélectrique et d'augmenter la capacité dans la région **32** mais ne règle pas de façon efficace le problème des capacités de fuite qui sont toujours présentes.

## EXPOSE DE L'INVENTION

Le but de la présente invention est de résoudre les problèmes susmentionnés en proposant un transistor organique à film mince, qui permette une capacité élevée au dessus du canal, une tension d'alimentation et des capacités parasites réduites.
A cet effet, l'invention a pour objet un transistor organique à film mince comportant :

- un élément conducteur formant drain ;
- un élément conducteur formant source espacé du drain ;
- un élément conducteur formant grille présentant une surface en regard du drain et une surface en regard de la source ;
- une couche semi-conductrice au contact du drain et de la source de manière à créer un canal de porteurs de charge entre le drain et la source ; et

■ une couche d'un premier matériau diélectrique de permittivité diélectrique inférieure à quatre, agencée entre d'une part la grille et d'autre part la source et le drain.

Selon l'invention :

• il comporte un volume d'un second matériau formé dans la couche de premier matériau au moins entre la grille et le canal de porteurs de charge, la portion dudit volume entre la grille et le canal de porteurs de charge ayant une section globalement décroissante depuis la grille vers le canal de porteurs de charge ;

• et la permittivité diélectrique relative du second matériau est supérieure à quatre.

Il est entendu que dans le présent document une permittivité diélectrique relative est dite faible lorsqu'elle est inférieure à 4 et élevée lorsqu'elle est supérieure à 4.

Par « globalement », on entend ici que la section du volume proche de la grille est supérieure à la section du volume proche de la région de la couche semi-conductrice entre le drain et la source dans laquelle se forme le canal de porteurs, la section du volume pouvant décroitre de manière monotone ou non.

En d'autres termes, la portion de diélectrique entre les surfaces en regard de la grille et de la source et la portion de diélectrique entre les surfaces en regard de la grille et du drain sont essentiellement constituées de diélectrique de faible valeur de permittivité diélectrique relative, réduisant de fait les capacités parasites. En outre, la portion de diélectrique entre la grille et le canal de porteurs se formant entre le drain et la source voit essentiellement du diélectrique ayant une valeur élevée de permittivité diélectrique relative. De fait, la capacité de cette portion de diélectrique est élevée, ce qui réduit les phénomènes d'hystérésis et permet de diminuer la tension entre la grille et le substrat nécessaire à la formation du canal de porteurs dans la couche semi-conductrice.

Par ailleurs, la section globalement décroissante du volume du second matériau crée dans la couche diélectrique un gradient de permittivité diélectrique. Ce gradient de permittivité diélectrique permet d'augmenter les performances du transistor.

On notera à cet égard que prévoir un volume de section constante au dessus de la région semi-conductrice dans laquelle se forme le canal de porteurs, comme un cylindre de matériau « high k » par exemple, ne permet pas d'obtenir un transistor fonctionnant de manière satisfaisante en raison de l'absence d'un tel gradient de permittivité relative.

De préférence, la permittivité diélectrique relative du premier matériau est inférieure ou égale à deux, et la permittivité diélectrique relative du second matériau est supérieure ou égale à huit.

Selon un mode de réalisation particulier de l'invention, le volume présente une section décroissante de manière monotone. Plus particulièrement, le volume est un volume de révolution, notamment conique, ou trapézoïdal.

En d'autres termes, le gradient de permittivité diélectrique décroit de manière monotone en fonction de l'épaisseur de la couche de diélectrique, ce qui concentre les lignes de champs électriques vers le canal de porteurs formé entre le drain et la source.

Selon un mode de réalisation particulier de l'invention, la couche de premier matériau comporte une portion du premier matériau diélectrique au dessus de l'espace entre le drain et la source.

En d'autres termes, une portion du premier matériau diélectrique est présente au dessus de la surface de la couche semi-conductrice, ce qui réduit les instabilités électriques dans le transistor.

Plus particulièrement, l'épaisseur de la portion du premier matériau diélectrique est inférieure à 400 nanomètres permettant ainsi d'obtenir une capacité élevée au dessus du canal de porteurs, tout en évitant les problèmes de courant de fuite et de claquage.

Selon un mode de réalisation particulier de l'invention, le second matériau est métallique. Plus particulièrement, la grille est métallique, et le volume du second matériau est formé d'un seul tenant avec celle-ci.

Selon une mode de réalisation particulier de l'invention, le second matériau est un diélectrique. Dans une première variante, le diélectrique est préférentiellement de l'alumine $Al_2O_3$. Dans une seconde variante, le second matériau comporte des nanocharges à permittivité diélectrique relative supérieure à quatre dispersées dans une matrice organique à permittivité diélectrique relative inférieure à quatre. Les nanocharges, qui ont en général un diamètre compris entre environ 30 nanomètres et environ 50 nanomètres, ont de préférence une permittivité diélectrique relative supérieure à 100, et sont des nanoparticules comprises dans le groupe constitué de $BaTiO_3$, $Ta_2O_5$, $Al_2O_3$ et $TiO_2$. Ces nanoparticules présentent l'avantage d'avoir une très forte permittivité diélectrique relative et leurs dimensions nanométriques permettent de les disperser de façon homogène dans un matériau à faible permittivité diélectrique relative.

Selon un mode de réalisation particulier de l'invention, le premier matériau diélectrique est du fluoropolymère ou du polystyrène.

L'invention a également pour objet un procédé de fabrication d'un transistor organique du type ci-dessus. Ce procédé comporte :

■ une étape de formation d'une couche d'un premier matériau diélectrique ;

■ une étape de dépôt, sur la surface de la couche du premier matériau, d'un mélange de solvant et de nanocharges présentant une permittivité diélectrique relative supérieure à celle du premier matériau ; et

■ une étape de chauffage de la couche du premier matériau diélectrique, la compétition entre l'évaporation du solvant par chauffage et la pénétration par absorption des nanocharges par le premier matériau diélectrique formant dans la couche du premier matériau un volume d'un second matériau de section globalement décroissante en fonction de l'épaisseur de la couche du premier matériau et de permittivité diélectrique relative supérieure à celle du premier matériau.

En d'autres termes, ce procédé est spécialement adapté pour la fabrication de la couche diélectrique entrant dans la constitution du transistor selon l'invention.

L'invention a également pour objet un procédé de fabrication d'un transistor organique présentant un gradient de permittivité diélectrique en fonction de son épaisseur, du type ci-dessus, ledit procédé comportant :

■ une étape de formation d'une couche d'un premier matériau diélectrique
■ une étape de gravure dans le premier matériau diélectrique d'une cavité ayant section globalement décroissant ; et
■ une étape de remplissage de ladite cavité par un second matériau présentant une permittivité diélectrique relative supérieure à celle du premier matériau.

En d'autres termes, ce procédé est spécialement adapté pour la fabrication de la couche diélectrique entrant dans la constitution du transistor selon l'invention.

**BREVE DESCRIPTION DES FIGURES**

La présente invention sera mieux comprise à la lecture de la description qui suit, réalisée en relation avec les dessins annexés, dans lesquels des références identiques désignent des éléments identiques ou analogues, et dans lesquels :

- la figure 1 est une vue schématique en section d'un premier transistor organique à film mince de l'état de la technique décrit dans le préambule ;
- la figure 2 est une vue schématique en section d'un second transistor organique à film mince de l'état de la technique décrit dans le préambule ;
- la figure 3 est une vue schématique en section d'un transistor organique à film mince selon une premier mode de réalisation de l'invention ;
- la figure 4 est une vue schématique en section d'un transistor organique à film mince selon une deuxième mode de réalisation de l'invention ;
- la figure 5 est une vue schématique de la couche diélectrique des transistors des figures 3 et 4 sur laquelle sont représentées des tranches élémentaires de celle-ci ;
- la figure 6 est une courbe illustrant l'évolution de la permittivité diélectrique relative de la couche semi-conductrice entrant dans la constitution des transistors des figures 3 et 4 en fonction de l'épaisseur de celle-ci ;
- la figure 7 est une courbe illustrant l'évolution de la capacité de la couche semi-conductrice entrant dans la constitution des transistors des figures 3 et 4 en fonction de la largeur de celle-ci ;
- la figure 8 est une vue schématique en section d'un transistor organique à film mince selon une troisième mode de réalisation de l'invention ;
- les figures 9 à 11 sont des vues schématiques illustrant un procédé de fabrication selon l'invention de la couche semi-conductrice entrant dans la constitution du transistor de la figure 4.

**DESCRIPTION DETAILLEE DE L'INVENTION**

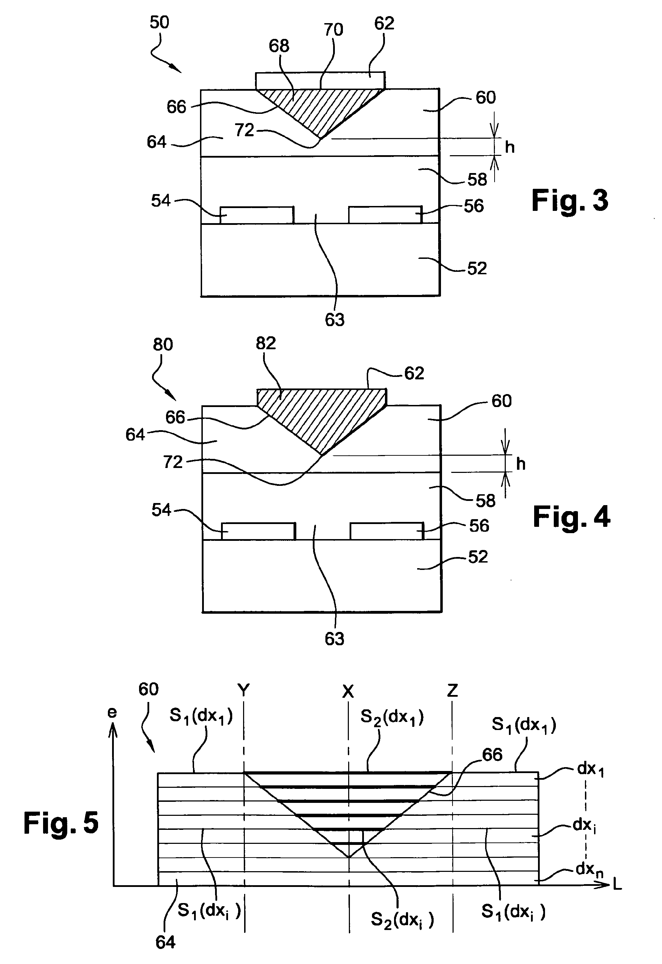

Sur la figure 3, un transistor organique à film mince selon un premier mode de réalisation de l'invention, présentant la structure « grille haute - contact bas », est illustré de manière schématique sous la référence générale **50**.

Le transistor **50** comporte un substrat **52** sur lequel sont formés deux éléments conducteurs **54**, **56**, constituant respectivement le drain et la source du transistor **50**. Une couche semi-conductrice **58** est déposée sur le drain **54** et la source **56**, la couche semi-conductrice **58** étant elle-même recouverte par une couche de diélectrique **60** sur laquelle est formé un troisième élément conducteur **62**, constituant la grille du transistor **50**.

Selon l'invention, la couche diélectrique **60** comporte une couche **64** de diélectrique « low k », notamment un polymère « low k » comme un fluoropolymère ou un polystyrène, dans laquelle est formée une cavité **66** remplie d'un diélectrique « high k ».

La cavité **66** formée dans la couche de diélectrique « low k » **64**, qui débute sous la grille **22** avec une grande surface **70**, présente une section décroissante en fonction de l'épaisseur de la couche **64**, la section minimale **72** de la cavité **66** faisant face à la portion **63** de semi-conducteur entre le drain **54** et la source **56** dans laquelle se forme le canal de porteurs. La cavité **66**, qui est de préférence un volume de révolution tel qu'un cône, se termine à une hauteur $\underline{h}$ de la couche de semi-conducteur **58**.

Dans une première variante, le diélectrique « high k » est de l'alumine $Al_2O_3$.

Dans une seconde variante, le diélectrique « high k » **68** remplissant la cavité **66**, comporte avantageusement des nanocharges « high k », de diamètre compris entre environ 30 nanomètres et environ 50 nanomètres et de permittivité diélectrique relative de préférence supérieure à 100, dispersées dans une matrice organique, telle que le polymère « low k » de la couche **64** par exemple, avec une densité supérieure ou égale à 6.08 g/ml. Par exemple, les nanocharges sont des nanoparticules de $BaTiO_3$, de $Ta_2O_5$, de $Al_2O_3$ ou de $TiO_2$.

Sur la figure 4, il est illustré un second mode de réalisation de l'invention. Le transistor **80** selon ce mode de réalisation est analogue à celui décrit en relation avec la figure 3, à la différence que la cavité **66**, formée dans la couche de diélectrique « low k » **64**, est remplie de métal **82**, et de préférence du même métal que celui qui constitue la grille **22** lorsque celle-ci est métallique. Dans un tel cas, la grille et le volume de métal remplissant la cavité **66** sont réalisés d'un seul tenant, ce qui augmente la robustesse mécanique du transistor et simplifie le processus de fabrication de celui-ci. On notera que la permittivité diélectrique relative d'un métal est supérieure à la permittivité diélectrique relative du diélectrique « low k » de la couche **64**.

Grâce à la formation de la cavité **66** remplie de diélectrique « high k » ou de métal dans la couche de diélectrique « low k » **64**, il est ainsi obtenu un gradient de permittivité diélectrique relative dans l'épaisseur de la couche **64**.

En effet, comme cela est visible sur la figure 5 qui illustre la couche de diélectrique **60**, la permittivité diélectrique relative $\varepsilon_r(dx_i)$ d'une tranche élémentaire « $dx_i$ » de la couche **60** est égale à :

$$\varepsilon_r(dx_i) = S_1(dx_i) \times \varepsilon_{r1} + S_2(dx_i) \times \varepsilon_{r2}$$

où

- $S_1(dx_i)$ est la surface de la portion de tranche élémentaire « $d_{xi}$ » correspondant au diélectrique « low k » de permittivité diélectrique relative $\varepsilon_{r1}$,
- et $S_2(dx_i)$ *est* la surface de la portion de tranche élémentaire « $dx_i$ » correspondant au matériau remplissant la cavité **66** (diélectrique « high k » **68** ou métal **82**) de permittivité diélectrique relative $\varepsilon_{r2}$.

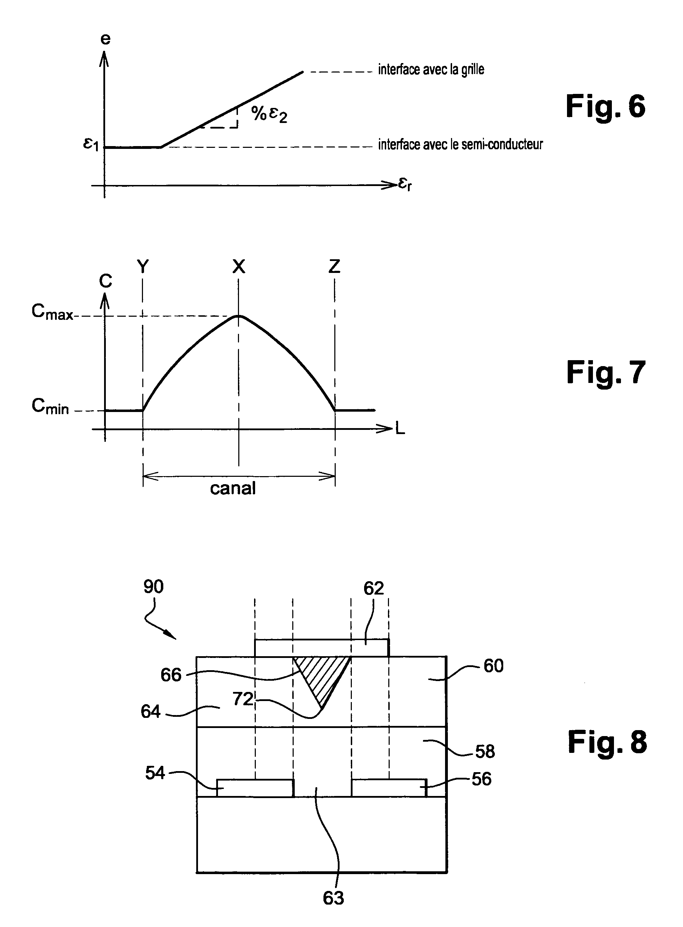

De fait, il existe en fonction de l'épaisseur $\underline{e}$ de la couche diélectrique **60**, un gradient de permittivité diélectrique, comme cela est visible à la figure 6. Cette figure illustre en abscisse la permittivité diélectrique relative équivalente de la couche **60** et en ordonnée, l'épaisseur de celle-ci. On notera ainsi qu'à l'interface avec la grille **62**, la permittivité diélectrique relative équivalente de la couche **60** est élevée et égale à $\varepsilon_r(dx_1) = S_1(dx_1) \times \varepsilon_{r1} + S_2(dx_1) \times \varepsilon_{r2}$, où $S_1(dx_i)$ est la surface de diélectrique « low k » au et $S_2(dx_i)$ la surface du matériau remplissant la cavité **66** niveau de ladite interface avec la grille **62**.

La section de la cavité **66**, ici un cône, décroit de façon monotone. La surface du matériau de la cavité **66** dans les tranches élémentaires diminue également. La permittivité diélectrique relative équivalente de la couche diélectrique **60** diminue donc à mesure qu'on se rapproche de la couche de semi-conducteur **58**, pour être égale à la permittivité diélectrique relative $\varepsilon_{r1}$ du diélectrique « low k » à l'interface avec la couche de semi-conducteur **58**.

Un tel gradient de permittivité diélectrique relative a pour effet d'améliorer la communication entre le champ électrique formé dans la couche de diélectrique **60** et la grille **62**, tout en augmentant la capacité équivalente de la portion de la couche diélectrique agencée au dessus du canal de porteurs. La géométrie de la couche de diélectrique **60** permet également d'avoir une épaisseur maximale de diélectrique « low k » au niveau du drain **54** et de la source **56**, afin de minimiser les capacités parasites présentes au niveau des surfaces de recouvrement entre d'une part la grille **62** et le drain **64**, et d'autre part la grille **62** et la source **56**.

Par ailleurs, le gradient de permittivité diélectrique dans la couche diélectrique **60** a pour effet d'augmenter les performances du transistor en concentrant les lignes de champ électrique vers le canal de porteurs formé entre le drain **54** et la source **56**.

La figure 7 illustre quant à elle l'évolution de la capacité équivalente de la couche diélectrique **60** en fonction de la largeur L de celle-ci. Grâce à la présence de la cavité **66** remplie de matériau de permittivité diélectrique supérieure à celle du diélectrique « low k », il est obtenu un profil avantageux de capacité. Selon ce profil, la capacité équivalente de la couche diélectrique **60** est maximale au niveau de l'axe de symétrie X de la cavité, c'est-à-dire au dessus de la portion **63** dans laquelle se forme le canal de porteurs, et diminue à mesure que l'on s'éloigne de cet axe, pour être minimale au niveau du drain **54** et de la source **56.**

Par ailleurs, la hauteur $\underline{h}$ de diélectrique « low k » présente sous la cavité **66** recouvre intégralement la couche semi-conductrice **58**, ce qui réduit les instabilités diélectriques dans le transistor.

On observe en outre que la valeur de la capacité équivalente de la couche diélectrique **60** au niveau du canal de porteurs dépend principalement de la hauteur de diélectrique « low k » recouvrant la couche semi-conductrice **58**, et plus particulièrement dépend de manière inverse de cette hauteur $\underline{h}$. Une hauteur $\underline{h}$ inférieure à 400 nanomètres permet notamment d'atteindre une capacité élevée entre la grille **62** et le canal de porteurs. A titre d'exemple, avec un diélectrique « low k » de permittivité diélectrique relative égale à 2, on obtient une capacité d'environ 4 nanofarads par $cm^2$. Comme cette capacité évolue peu pour des valeurs de hauteur $\underline{h}$ supérieure à 400 nanomètres, en choisissant une hauteur $\underline{h}$ inférieure à 400 nanomètres, on a donc une capacité élevée tout en évitant des problèmes électriques tels que des courants de fuite ou des claquages.

Bien qu'un diélectrique « high k » et un métal définissent chacun un gradient de permittivité diélectrique relative et une capacité variable lorsqu'ils forment un volume décroissant dans une couche de diélectrique « low k », un gradient de permittivité diélectrique relative plus important est obtenu à l'aide du diélectrique « high k » qu'avec du métal. Inversement, une variation de capacité plus importante est obtenue à l'aide d'un métal qu'avec un diélectrique « high k ». Le choix des matériaux utilisés pour remplir la cavité **66** dépend donc de l'application visée. Par exemple si le matériau « low k » est de faible qualité, le matériau remplissant la cavité **66** est préférentiellement un diélectrique « high k », comme un céramique « high k » par exemple. A l'inverse, si le matériau « low k » est de bonne qualité, le matériau remplissant la cavité **66** peut présenter une permittivité diélectrique relative pas très élevée, et peut être du métal.

Bien entendu, l'invention n'est pas limitée aux exemples décrits ci-dessus.

Bien qu'un volume, dont la section décroît de manière monotone en fonction de l'épaisseur de la couche de diélectrique « low k », soit préféré pour éviter les capacités parasites de recouvrement, un gradient de permittivité et une capacité variable sont obtenus quelle que soit la forme du volume dès lors que celui-ci présente une surface à l'interface avec la grille plus grande que la surface en regard de la région de la couche semi-conductrice **58** dans laquelle est formé le canal de porteurs. Par exemple, le volume peut être trapézoïdal ou pyramidal. Notamment, le choix du type de section de la cavité **66** (circulaire, carrée, etc...) peut être dicté par la forme de la grille **62** s'il est décidé que la cavité **66** recouvre exactement la grille **62**.

De même, il a été décrit en relation avec les figures 3 et 4 une cavité **66** qui recouvre exactement la grille **62**. De fait la couche diélectrique **60** comporte des portions de diélectrique « high k » ou de métal entre les surfaces en regard de la grille **62** et du drain **54** et de la source **56**.

En variante, tel que cela est illustré à la figure 8, la cavité **66** est formée uniquement dans la portion du diélectrique « low k » au dessus de la portion **63** de la couche semi-conductrice **58** dans laquelle se forme le canal de porteurs. Les capacités parasites sont ainsi encore réduites.

De même, il a été décrit des transistors présentant une structure dite « grille haute - contact bas » (plus communément connue sous l'expression anglo-saxonne « *top gate-bottom contact* »). Bien entendu, la présente invention s'applique également aux structures de transistors dites « grille basse-contact bas » (ou « *bottom gate - bottom contact* »), « grille haute - contact haut » (ou « *top gate - top contact* ») et « grille basse - contact haut » (ou « *bottom gate - top contact* »).

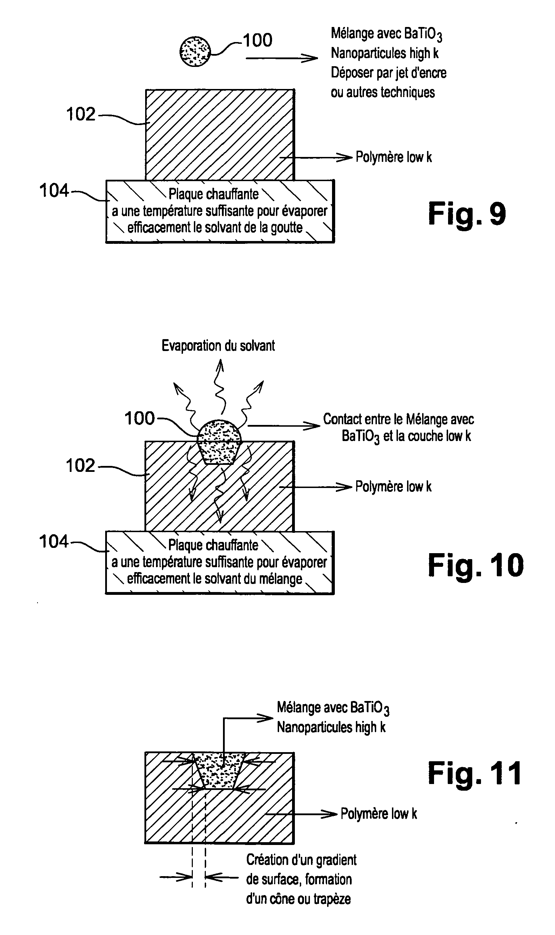

Les figures 9 à 11 illustrent un premier procédé de fabrication d'une couche de diélectrique « low k » dans laquelle est aménagé un volume de section décroissante de diélectrique « high k », telle que mise en oeuvre dans un transistor selon l'invention.

Dans une première étape illustrée à la figure 9, une goutte **100** d'un mélange de nanoparticules de diélectrique « high k », comme des nanoparticules de $BaTiO_3$, de $Ta_2O_5$, de $Al_2O_3$ ou de $TiO_2$, et de solvant est déposée, par exemple par une technique de jet d'encre, sur la surface d'une couche de diélectrique « low k » **102,** et plus particulièrement un polymère « low k » tel qu'un polymère fluoré comme le polystyrène de permittivité diélectrique relative comprise entre 2 et 2,5.

Comme illustré à la figure 10, la couche de polymère « low k » **102** est alors chauffée, par exemple au moyen d'une plaque chauffante **104** sur laquelle elle repose, à une température suffisante pour évaporer efficacement le solvant de la goutte déposée **100,** par exemple la température d'évaporation du solvant. Par exemple en utilisant du toluène comme solvant, une température de chauffage égale à environ 100°C est choisie.

Un phénomène de compétition entre l'évaporation de la goutte **100** et la pénétration de celle-ci dans le polymère **102** est alors observé. La goutte **100** se dissout ainsi partiellement dans le polymère **102** en formant un volume de section décroissante de nanocharges « high k » dispersées dans une matrice organique (ici le polymère « low k »), tel un cône ou un cône tronqué (figure 11).

Le choix du solvant ainsi que celui de la température permet notamment de régler la profondeur de pénétration des nanoparticules dans le polymère, et donc la forme fmale du volume de diélectrique « high k » dans la couche de diélectrique « low k ».

Selon un second procédé de fabrication d'une couche de diélectrique pour transistor organique selon l'invention, une couche d'un premier matériau diélectrique « low k » est gravée, par exemple par une attaque chimique, une abrasion laser, un emboutissage ou autres, pour former dans celle-ci une cavité ayant une section globalement décroissante comme un cône par exemple.

La cavité ainsi formée est alors remplie d'un second matériau présentant une permittivité diélectrique relative supérieure à celle du premier matériau, comme un diélectrique « high k » ou un métal, le remplissage étant par exemple réalisé au moyen d'une dispersion d'un liquide ou au moyen d'un dépôt par pulvérisation après masquage des zones de la couche du premier matériau à ne pas modifier.

## Revendications

1. Transistor organique (50 ; 80 ; 90) comportant :

   ■ un élément conducteur formant drain (54) ;
   ■ un élément conducteur formant source (56) espacé du drain (54) ;
   ■ un élément conducteur formant grille (62), présentant une surface en regard du drain (54) et une surface en regard de la source (56) ;
   ■ une couche semi-conductrice (58) au contact du drain (54) et de la source (56) de manière à créer un canal de porteurs de charge entre le drain (54) et la source (56); et
   ■ une couche (64) d'un premier matériau diélectrique de permittivité diélectrique inférieure à quatre, agencée entre d'une part la grille (62) et d'autre part la source (56) et le drain (54),

*caractérisé* **en ce qu'**il comporte un volume (66) d'un second matériau (68 ; 82) formé dans la couche (64) de premier matériau au moins entre la grille (62) et le canal de porteur de charge, la portion dudit volume (66) entre la grille (62) et le canal de porteur de charge ayant une section globalement décroissante depuis la grille (62) vers le canal de porteurs, et **en ce que** la permittivité diélectrique relative du second matériau est supérieure à quatre.

**2.** Transistor organique selon la revendication 1, *caractérisé* **en ce que** la permittivité diélectrique relative du premier matériau est inférieure ou égale à deux, et **en ce que** la permittivité diélectrique relative du second matériau est supérieure ou égale à huit.

**3.** Transistor organique selon l'une des revendications 1 et 2, *caractérisé* **en ce que** le volume (66) présente une section décroissante de manière monotone.

**4.** Transistor organique selon la revendication 3, *caractérisé* **en ce que** le volume (66) est un volume de révolution, notamment conique, ou trapézoïdal.

**5.** Transistor organique selon l'une des revendications 1 à 4, *caractérisé* **en ce que** la couche (64) de premier matériau comporte une portion h du premier matériau diélectrique au dessus de l'espace (63) entre le drain (54) et la source (56).

**6.** Transistor organique selon la revendication 5, *caractérisé* **en ce que** l'épaisseur de la portion h du premier matériau diélectrique est inférieure à 400 nanomètres.

**7.** Transistor organique selon l'une quelconque des revendications précédentes, *caractérisé* **en ce que** le second matériau (82) est métallique.

**8.** Transistor organique selon la revendication 7, *caractérisé* **en ce que** la grille (62) est métallique, et **en ce que** le volume (66) du second matériau (82) est formé d'un seul tenant avec celle-ci.

**9.** Transistor organique selon l'une quelconque des revendications 1 à 6, *caractérisé* **en ce que** le second matériau (68) est un diélectrique.

**10.** Transistor organique selon la revendication 9, *caractérisé* **en ce que** le second matériau (68) est de l'alumine.

**11.** Transistor organique selon la revendication 9, *caractérisé* **en ce que** le second matériau (68) comporte des nanocharges à permittivité diélectrique relative supérieure à quatre dispersées dans une matrice organique à permittivité diélectrique relative inférieure à quatre.

**12.** Transistor organique selon la revendication 11, *caractérisé* **en ce que** les nanocharges ont une permittivité diélectrique relative supérieure à 100.

**13.** Transistor organique selon l'une des revendications 11 ou 12, *caractérisé* **en ce que** les nanocharges sont des nanoparticules comprises dans le groupe constitué de $BaTiO_3$, $Ta_2O_5$, $Al_2O_3$ et $TiO_2$.

**14.** Transistor organique selon l'une quelconque des revendications précédentes, *caractérisé* **en ce que** le premier matériau diélectrique est du fluoropolymère ou du polystyrène.

**15.** Procédé de fabrication d'un transistor organique selon l'une quelconque des revendications précédente, ledit procédé comportant :

■ une étape de formation de la couche de premier matériau diélectrique ;
■ une étape de dépôt, sur la surface de la couche du premier matériau, d'un mélange de solvant et de nanocharges présentant une permittivité diélectrique relative supérieure à celle du premier matériau ; et
■ une étape de chauffage de la couche du premier matériau diélectrique, la compétition entre l'évaporation du solvant par chauffage et la pénétration par absorption des nanocharges par le premier matériau diélectrique formant dans la couche du premier matériau le volume de second matériau de section globalement décroissante en fonction de l'épaisseur de la couche du premier matériau et de permittivité diélectrique relative supérieure à celle du premier matériau.

**16.** Procédé de fabrication d'un transistor organique selon l'une quelconque des revendications 1 à 14, ledit procédé comportant :

■ une étape de formation de la couche de premier matériau diélectrique ;
■ une étape de gravure dans le premier matériau diélectrique d'une cavité ayant section globalement décroissante ; et
■ une étape de remplissage de ladite cavité par un second matériau présentant une permittivité diélectrique relative supérieure à celle du premier matériau, de manière à former le volume de second matériau.

**Claims**

**1.** Organic transistor (50; 80; 90) comprising:

- a conductive element which forms a drain (54);
- a conductive element which forms a source (56) located away from the drain (54);
- a conductive element which forms a gate (62) having a surface which faces the drain (54) and a surface which faces the source (56);
- a semiconducting layer (58) which is in contact with the drain (54) and the source (56) in order to generate a charge-carrier channel formed between the drain (54) and the source (56); and
- a layer (64) of a first dielectric material having a dielectric permittivity less than four, located between, firstly, the gate (62) and, secondly, the source (56) and the drain (54),

*characterized* in that it comprises a volume (66) of a second material formed within the layer (64) of the first material at least between the gate (62) and the charge carrier channel, the portion of said volume (66) between the gate (62) and the charge carrier channel having an overall cross-section which tapers from gate (62) towards the charge carrier channel, and **in that** the relative dielectric permittivity of the second material exceeds four.

2. Organic transistor as claimed in claim 1, *characterized* **in that** the relative dielectric permittivity of the first material is equal to or less than two and the relative dielectric permittivity of the second material is equal to or greater than eight.

3. Organic transistor as claimed in either claim 1 or 2, *characterized* **in that** the volume (66) has a cross-section which tapers monotonically.

4. Organic transistor as claimed in claim 3, *characterized* **in that** the volume (66) is a revolution volume, especially a conical or trapezoidal volume.

5. Organic transistor as claimed in any of claims 1 to 4, *characterized* **in that** the dielectric layer (64) of the first material comprises a portion h̲ of the first dielectric material above space (63) between drain (54) and source (56).

6. Organic transistor as claimed in claim 5, *characterized* **in that** the thickness of portion h̲ of the first dielectric material is less than 400 nanometers.

7. Organic transistor as claimed in any of the above claims, *characterized* **in that** the second material (82) is metallic.

8. Organic transistor as claimed in claim 7, *characterized* **in that** gate (62) is metallic and **in that** the volume (66) of the second material (82) is formed in a single piece integrally with the latter.

9. Organic transistor as claimed in any of claims 1 to 6, *characterized* **in that** second material (68) is a dielectric.

10. Organic transistor as claimed in claim 9, *characterized* **in that** the second material (68) is alumina.

11. Organic transistor as claimed in claim 9, *characterized* **in that** the second material (68) comprises nanocharges having a relative dielectric permittivity greater than four dispersed in an organic matrix having a relative dielectric permittivity of less than four.

12. Organic transistor as claimed in claim 11, *characterized* **in that** the nanocharges have a relative dielectric permittivity in excess of 100.

13. Organic transistor as claimed in either claim 11 or 12, *characterized* **in that** the nanocharges are nanoparticles selected from the group comprising $BaTiO_3$, $Ta_2O_5$, $Al_2O_3$ and $TiO_2$.

14. Organic transistor as claimed in any of the above claims, *characterized* **in that** the first dielectric material is a fluoropolymer or polystyrene.

15. A method for fabricating an organic transistor according to anyone of the preceding claims, said method consisting of:

- a step to form the layer of the first dielectric material;
- a step to deposit, on the surface of the first material, a mixture of solvent and nanocharges having a relative dielectric permittivity greater than that of the first material; and
- a step to heat the layer of the first dielectric material, with evaporation of the solvent by heating and penetration of the nanocharges by absorption into the first dielectric material forming, in the layer of the first material, the volume of the second material having an overall cross-section which tapers as a function of the thickness of the layer of the first material and having a relative dielectric permittivity which is greater than that of the first material.

16. A method for fabricating an organic transistor according to anyone of claims 1 to 14, said method consisting of:

- a step to form the layer of the first dielectric material;
- a step to etch, in the first dielectric material, a cavity having an overall tapering cross-section; and
- a step to fill said cavity with a second material having a relative dielectric permittivity greater than that of the first material, in order to form the volume of the second material.

**Patentansprüche**

1. Organischer Transistor (50; 80; 90), umfassend

   ■ ein Leiterelement, das einen Drain (54) bildet;
   ■ ein vom Drain (54) beabstandetes Leiterelement, das eine Source (56) bildet;
   ■ ein Leiterelement, das ein Gatter (62) bildet, das eine Fläche gegenüber dem Drain (54) und eine Fläche gegenüber der Source (56) aufweist;
   ■ eine Halbleiterschicht (58), die mit dem Drain (54) und der Source (56) in Kontakt ist, um einen Ladungsträgerkanal zwischen dem Drain (54) und der Source (56) zu schaffen; und
   ■ eine Schicht (64) aus einem ersten dielektrischen Material mit einer dielektrischen Permittivität von unter Vier, die einerseits zwischen dem Gatter (62) und andererseits der Source (56) und dem Drain (54) ausgebildet ist,

   **dadurch gekennzeichnet, dass** er ein Volumen (66) aus einem zweiten Material (68; 82) umfasst, das in der Schicht (64) aus dem ersten Material zumindest zwischen dem Gatter (62) und dem Ladungsträgerkanal gebildet ist, wobei der Abschnitt des Volumens (66) zwischen dem Gatter (62) und dem Ladungsträgerkanal einen vom Gatter (62) zum Trägerkanal insgesamt abnehmenden Querschnitt hat, und dass die relative dielektrische Permittivität des zweiten Materials höher als Vier ist.

2. Organischer Transistor nach Anspruch 1, **dadurch gekennzeichnet, dass** die relative dielektrische Permittivität des ersten Materials kleiner oder gleich Zwei ist, und dass die relative dielektrische Permittivität des zweiten Materials größer oder gleich Acht ist.

3. Organischer Transistor nach einem der Ansprüche 1 und 2, **dadurch gekennzeichnet, dass** das Volumen (66) einen monoton abnehmenden Querschnitt aufweist.

4. Organischer Transistor nach Anspruch 3, **dadurch gekennzeichnet, dass** das Volumen (66) ein insbesondere konisches oder trapezförmiges rotationssymmetrisches Volumen ist.

5. Organischer Transistor nach einem der Ansprüche 1 bis 4, **dadurch gekennzeichnet, dass** die Schicht (64) aus dem ersten Material einen Abschnitt <u>h</u> aus dem ersten dielektrischen Material über dem Raum (63) zwischen dem Drain (54) und der Source (56) umfasst.

6. Organischer Transistor nach Anspruch 5, **dadurch gekennzeichnet, dass** die Dicke des Abschnitts <u>h</u> aus dem ersten dielektrischen Material geringer als 400 Nanometer ist.

7. Organischer Transistor nach einem der vorhergehenden Ansprüche, **dadurch gekennzeichnet, dass** das zweite Material (82) metallisch ist.

8. Organischer Transistor nach Anspruch 7, **dadurch gekennzeichnet, dass** das Gatter (62) metallisch ist, und dass das Volumen (66) aus dem zweiten Material (82) in einem Stück mit diesem ausgebildet ist.

9. Organischer Transistor nach einem der Ansprüche 1 bis 6, **dadurch gekennzeichnet, dass** das zweite Material (68) ein Dielektrikum ist.

10. Organischer Transistor nach Anspruch 9, **dadurch gekennzeichnet, dass** das zweite Material (68) Aluminiumoxid ist.

11. Organischer Transistor nach Anspruch 9, **dadurch gekennzeichnet, dass** das zweite Material (68) Nanoladungen mit einer relativen dielektrischen Permittivität von über Vier umfasst, die in einer organischen Matrix mit einer relativen dielektrischen Permittivität von unter Vier verteilt sind.

12. Organischer Transistor nach Anspruch 11, **dadurch gekennzeichnet, dass** die Nanoladungen eine relative dielektrische Permittivität von über 100 haben.

13. Organischer Transistor nach einem der Ansprüche 11 oder 12, **dadurch gekennzeichnet, dass** die Nanoladungen Nanopartikel sind, die in der Gruppe enthalten sind, die aus $BaTiO_3$, $Ta_2O_5$, $Al_2O_3$ und $TiO_2$ besteht.

14. Organischer Transistor nach einem der vorhergehenden Ansprüche, **dadurch gekennzeichnet, dass** das erste dielektrische Material Fluorpolymer oder Polystyrol ist.

15. Verfahren zur Herstellung eines organischen Transistors nach einem der vorhergehenden Ansprüche, wobei das Verfahren umfasst:

   ■ einen Schritt des Ausbildens der Schicht aus erstem dielektrischen Material;
   ■ einen Schritt des Abscheidens auf der Oberfläche der Schicht aus dem ersten Material eines Gemischs aus Lösungsmittel und Nanoladungen, die eine relative dielektrische Permittivität aufweisen, die höher ist als diejenige des ersten Materials; und

■ einen Schritt des Erwärmens der Schicht aus dem ersten dielektrischen Material, wobei die Konkurrenz zwischen der Verdunstung des Lösungsmittels durch Erwärmung und der Penetration durch Absorption der Nanoladungen durch das erste dielektrische Material in der Schicht aus dem ersten Material das Volumen aus zweitem Material mit einem in Abhängigkeit von der Dicke der Schicht aus erstem Material insgesamt abnehmenden Querschnitt und einer relativen dielektrischen Permittivität bildet, die höher ist als diejenige des ersten Materials.

16. Verfahren zur Herstellung eines organischen Transistors nach einem der Ansprüche 1 bis 14, wobei das Verfahren umfasst:

■ einen Schritt des Ausbildens der Schicht aus erstem dielektrischen Material;
■ einen Schritt des Ätzens eines Hohlraums mit einem insgesamt abnehmenden Querschnitt in das erste dielektrische Material; und
■ einen Schritt des Füllens des Hohlraums mit einem zweiten Material, das eine relative dielektrische Permittivität aufweist, die höher ist als diejenige des ersten Materials, um das Volumen aus dem zweiten Material auszubilden.

**Fig. 1**

Etat de la technique

**Fig. 2**

Etat de la technique

Fig. 3

Fig. 4

Fig. 5

e

%ε₂

interface avec la grille

ε₁

interface avec le semi-conducteur

εᵣ

# Fig. 6

Y  X  Z

C

C_max

C_min

L

canal

# Fig. 7

90  62

66  60

72  64  58

54  56

63

# Fig. 8

—100 → Mélange avec BaTiO$_3$
Nanoparticules high k
Déposer par jet d'encre
ou autres techniques

102 → → Polymère low k

104 → Plaque chauffante
a une température suffisante pour évaporer
efficacement le solvant de la goutte

**Fig. 9**

Evaporation du solvant

100 → → Contact entre le Mélange avec
BaTiO$_3$ et la couche low k

102 → → Polymère low k

104 → Plaque chauffante
a une température suffisante pour évaporer
efficacement le solvant du mélange

**Fig. 10**

Mélange avec BaTiO$_3$
Nanoparticules high k

**Fig. 11**

→ Polymère low k

Création d'un gradient
de surface, formation
d'un cône ou trapèze